# FASCICULE DE BREVET EUROPEEN

(11) **EP 1 713 959 B1**
(45) Date de publication et mention de la délivrance du brevet: **29.11.2017**
(21) Numéro de dépôt: 05717520.0
(22) Date de dépôt: 31.01.2005
(51) Int. Cl.: C23C 16/26, B82Y 30/00, B82Y 40/00

(54) **PROCEDE D OBTENTION DE NANOTUBES DE CARBONE SUR DES SUPPORTS**
VERFAHREN ZUR HERSTELLUNG VON KOHLENSTOFFNANORÖHREN AUF TRÄGERN
METHOD FOR OBTAINING CARBON NANOTUBES ON SUPPORTS

(30) Priorité: 30.01.2004 FR 0400916; 29.04.2004 FR 0404586
(43) Date de publication de la demande: 25.10.2006
(73) Titulaire: CENTRE NATIONAL DE LA RECHERCHE SCIENTIFIQUE -CNRS-, 75794 Paris Cedex 16 (FR)
(72) Inventeur: BAI, JinBo, F-92160 Antony (FR); CI, Li-Jie, Troy, NY 12180 (US); ZHAO, Zhig-Gang, Tsukuba, Ibaraki, 305-0047 (JP)
(74) Mandataire: Novagraaf Technologies
(86) Numéro de dépôt international: PCT/FR2005/000201
(87) Numéro de publication internationale: WO 2005/075341

(56) Documents cités:
- EP-A- 0 913 508
- WO-A-00/63115
- US-A1- 2003 118 815
- US-A1- 2003 202 930
- US-B1- 6 495 258
- MA R ET AL: "CATALYTIC GROWTH OF CARBON NANOFIBERS ON A POROUS CARBON NANOTUBES SUBSTRATE" JOURNAL OF MATERIALS SCIENCE LETTERS, CHAPMAN AND HALL LTD. LONDON, GB, vol. 19, no. 21, 1 novembre 2000 (2000-11-01), pages 1929-1931, XP001006576 ISSN: 0261-8028

## Description

L'invention a pour objet un procédé d'obtention de nanotubes de carbone (NTC en abrégé) sur des supports, plus spécialement selon la méthode CVD (Chemical Vapor Deposition). Elle vise également leurs applications, en particulier pour élaborer des matériaux composites, ainsi que les utilisations de ces matériaux.

On sait que les nanotubes de carbone ont été proposés comme charges pour renforcer les structures de matériaux composites. Cependant, malgré les propriétés très intéressantes des NTC, jusqu'à présent, la plupart des résultats expérimentaux de leurs composites montrent un effet de renforcement plutôt médiocre. Comme raisons principales, on mentionnera la mauvaise qualité des NTC utilisés, la détérioration des propriétés des NTC lors de leur purification, la mauvaise dispersion et/ou la destruction des NTC lors de la dispersion, l'interface faible entre les NTC et les matrices, la difficulté de l'alignement des NTC dans les matrices et, souvent, un pourcentage massique trop fort de NTC ajoutés. US2003/202930, US 6495258 et EP 0913508 décrivent des procédés de croissance de NTC par CVD dans des structure nano/micrométriques en utilisant un catalyseur. Les composites comportant des renforts conventionnels (de dimension micrométrique) développés depuis quelques décennies n'ont pas eu d'applications très étendues, en raison notamment de la faible interface entre les renforts et la matrice. Le mécanisme d'endommagement le plus souvent observé est la décohésion et/ou la fissuration à l'interface due à la concentration de contraintes ou aux contraintes provoquées par la différence de leurs propriétés et de leurs coefficients de dilatation thermique.

Il est souvent nécessaire d'utiliser un taux élevé de renforts pour améliorer les propriétés des matrices, ce qui entraîne de nombreuses difficultés lors de la mise en oeuvre, de la mise en forme, de l'éventuel usinage du recyclage des matériaux. Les applications de ces composites sont alors limitées du fait de leur fragilité. Dans certains cas, les stabilités thermique et chimique des renforts postent aussi des problèmes dans les applications à moyenne et haute température et pendant les traitements thermiques de ces composites avant la mise en service.

La présente invention a pour but de mettre en valeur et en oeuvre les effets de renforcement à différentes échelles (nanométrique et micrométrique) et d'activer les mécanismes à l'échelle nanométrique (par exemple blocage du mouvement de dislocation et de chaînes moléculaires,amorçage de microfissures et de cavités) et à l'échelle micrométrique (propagation de fissuration et de cavitation).

Afin de disposer de matériaux composites plus satisfaisants au regard des exigences requises, les inventeurs ont ainsi développé une technique, selon la méthode CVD, de croissance de nanotubes de carbone constituant des renforts nano-échelles, ayant des liaisons et des morphologies optimisées sur des supports correspondant à des renforts micrométriques.

Cette technique permet de moduler, selon l'application envisagée, la densité, la longueur et l'attachement des NTC aux supports.

L'invention fournit donc un procédé pour l'obtention *in situ* de nanotubes de carbone sur des supports nano/micrométriques.

Elle vise également leur utilisation pour élaborer des matériaux composites et les applications de ces derniers.

Le procédé, selon l'invention, d'obtention de nanotubes par croissance selon la méthode CVD, sur des supports nano ou micrométriques comme décrit dans la revendication 1. Selon un mode de réalisation de l'invention, la croissance des nanotubes est réalisée selon un procédé caractérisé en ce qu'il comprend également :
- le chauffage, dans une enceinte réactionnelle, d'un matériau support, à une température de 600-1100°C, sous un courant de gaz inerte,
- le refroidissement de l'enceinte jusqu'à la température ambiante,
- la récupération du produit formé.

L'enceinte réactionnelle est avantageusement un four tubulaire avec un système de circulation de gaz.

Le matériau-support utilisé est choisi parmi ceux capables de supporter la température de dépôt des NTC.

Il s'agit avantageusement de fibres de carbone ou d'un matériau céramique préférentiellement sous forme de particules ou de fibres, de dimension nano/micrométrique.

Comme matériaux céramiques appropriés, on citera les fibres de carbone, les fibres de verre, les particules et fibres de SiC, TiC, Al₂O₃, SiO₂, B₄C, des fumées de silice, les argiles (grains d'argile), ou les fils comportant un matériau métallique tel que Fe, Ni, Co, Ti, Pt, Au, Y, Ru, Rh, ou Pd, Zr, Cr ou Mn.

Avec les matériaux renfermant C, Si, Ti, B, Fe dans leur composition, on peut établir une liaison forte entre les NTC et les supports en formant des ponts C-C, Si-C, Ti-C, B-C, Fe-C.

Pour des applications qui nécessitent une liaison particulièrement forte, des traitements thermiques à séquence précise peuvent être appliqués après le dépôt afin de consolider (ou souder) davantage l'adhésion.

Le composé source de carbone est choisi avantageusement parmi les hydrocarbures liquides du groupe comprenant le xylène, le toluène, le benzène, ou le n-pentane, ou encore des alcools, comme l'éthanol ou le méthanol, ou des cétones, comme l'acétone. En variante, le composé source de carbone est un hydrocarbure gazeux, tel que l'acétylène, le méthane, le butane, le propylène, l'éthylène et le propène. Selon encore une autre variante, le composé source de carbone est solide. Il s'agit par exemple de camphore.

Comme catalyseur, on aura recours avec avantage, à un composé choisi dans le groupe comprenant un métallocène de fer, de cobalt ou de nickel, ou encore à des nitrates, des acétates ou des sulfates de fer, de cobalt ou de nickel, notamment de la Fe(II), phtalocyanine (FePc), du pentacarbonyle de fer (Fe(CO)₅).

De préférence, le catalyseur et le composé source de carbone sont utilisés à raison de 0,001 à 0,1 g de catalyseur par ml de composé.

Le rapport de gaz inerte et d'hydrogène est de 5/95 à 50/50.

La mise en oeuvre des dispositions qui précèdent permet, en contrôlant la croissance des NTC à la surface des particules et fibres de céramique, ou des fibres de carbone de recouvrir uniformément les supports céramiques et d'améliorer les propriétés d'interface entre les nanotubes et les supports comme souhaité pour une application donnée.

Ces propriétés peuvent être également améliorées en soumettant le matériau support à une étape de pré-traitement. L'invention vise en particulier un procédé d'obtention de nanotubes par croissance sur des supports comportant, avant la dite étape de chauffage du matériau support, la mise en oeuvre d'un composé comprenant du silicium dans des conditions permettant le dépôt de silicium ou d'un dérivé de silicium, tel que SiC, SiO ou SiO₂ à la surface des supports.

Le composé comprenant du silicium mis en oeuvre est par exemple SiO ou un silane comme SiCl₄.

Les produits obtenus sont caractérisés en ce qu'il s'agit de composites multi-échelles, formés de nanotubes de carbone liés à des matériaux supports nano/micrométriques de fibres de carbone, ou de céramiques, tel que défini ci-dessus.

Ces composites multi-échelles constituent des renforts de grand intérêt pour des matrices polymères, céramiques et métalliques.

La présence des renforts nanométriques (de densité, de longueur et de liaison optimisées selon les matrices et les propriétés à améliorer) permet de :
a) renforcer la matrice près de l'interface (renforts conventionnels/matrice) ;
b) améliorer l'adhésion entre les renforts conventionnels et la matrice ;
c) retarder ou empêcher l'amorçage et la propagation de l'endommagement et/ou de la fissuration à l'interface ;
d) réduire la différence (ou le saut) de diverses propriétés entre les renforts conventionnels et la matrice telles le coefficient de dilatation thermique et les propriétés mécaniques pour éviter la génération de contraintes résiduelles importantes à l'interface, notamment lors de cycles thermiques ou mécaniques.

L'invention vise donc également des matériaux composites caractérisés en ce qu'ils, comportent des NTC liés à des supports nano/micrométriques dans une matrice.

La fabrication des matériaux composites est adaptée selon le type de matrice.

Pour les composites à matrices céramiques ou fragiles, des NTC courts et de densité relativement faible doivent être déposés sur la surface des renforts conventionnels pour obtenir un contact intime entre la surface des renforts conventionnels et la matrice. On obtient alors un ancrage mécanique des NTC attachés à la surface des renforts conventionnels.

Pour les composites à matrices ductiles (métaux et polymères), des NTC longs et de densité relativement forte doivent être déposés sur la surface des renforts conventionnels. On a recours à un procédé de type infiltration, éventuellement sous pression (de métaux et de polymères liquides) pour obtenir un contact intime entre la surface des renforts conventionnels et la matrice. Deux mécanismes de renforcement sont possibles. Le premier, par effet d'ancrage mécanique grâce à la présence des NTC ayant une forte liaison entre ces NTC et la surface ; le deuxième mécanisme étant le blocage des mouvements des chaînes moléculaires dans le cas des matrices polymériques et des mouvements de dislocations dans le cas des matrices métalliques et des matrices polymériques cristallisées. Ce deuxième mécanisme est particulièrement efficace avec des renforts nano-échelles. Les NTC obtenus selon l'invention sont alors particulièrement appropriés étant donné qu'ils sont véhiculés par les renforts conventionnels et bien dispersés dans les matrices.

De tels composites sont particulièrement appropriés dans le domaine des matériaux de structures, de la protection de matériaux, la fonctionnalisation et l'amélioration de surfaces, la filtration ou séparation sélective, la fabrication d'écrans plats et d'émissions de champs et pour le stockage de l'hydrogène. On citera également les applications en optique, thermique et furtivité. On notera avec intérêt que les produits de l'invention sont moins volatiles que les NTC obtenus jusqu'à présent, ce qui les rend avantageux eu égard aux règles de sécurité.

De manière générale, les matériaux multi-échelles et multi-fonctionnels de l'invention sont donc utilisables dans de nombreuses applications :
- les matériaux micro/nanoéchelles peuvent être ajoutés aux supports nano/micrométriques couverts de nanotubes dans des matrices polymères, céramiques ou métalliques ;
- les matériaux composites à matrices céramiques peuvent être obtenus en compactant les supports nano/micrométriques couverts de nanotubes ;
- ces matériaux peuvent être le cas échéant fonctionnalisés et utilisés pour la filtration ou la séparation sélective des fluides, des gaz ou autres.

Les supports couverts de nanotubes de carbone peuvent être en outre utilisés en tant que points d'émission de champ.

La croissance de NTC sur des supports tels qu'indiqués ci-dessus, par exemple des poudres explosives, des combustibles permet d'améliorer ou de conférer à ces matériaux des propriétés nouvelles conduisant à des applications nouvelles.

D'autres caractéristiques et avantages de l'invention seront donnés dans les exemples qui suivent et en se référant aux figures 1 à 10, qui représentent des photos en SEM, respectivement,
- figure 1a : de particules de SiC brutes ; figure 1b : de particules de SiC à faible grossissement avec un revêtement de nanotubes de carbone ; figures 1c et 1d : d'un agrandissement de 2 particules de SiC recouvertes de nanotubes de carbone ;
- figure 2a : de particules de SiC avec un revêtement moins dense de nanotubes de carbone ; figure 2b : d'un zoom sur des particules de SiC, avec une croissance dispersée et des nanotubes de carbone plus courts à partir de la surface ;
- figure 3a:de fibres de carbone ayant subi un pré-traitement conforme à l'invention ;figure 3b : de leur spectre Raman ;figure3c : de leur spectre EDX ;
- figure 4a : de fibres de Al₂O₃ brutes ; figure 3b : d'un faible agrandissement de fibres de Al₂O₃ recouvertes de nanotubes de carbone ; figure 4c : d'un zoom sur des fibres d'Al₂O₃ avec un revêtement de nanotubes de carbone plus longs ;
- figures 5a à 5c : de fibres de SiC avec un revêtement de nanotubes alignés ; figure 5d :de nanotubes avec une croissance perpendiculaire à la surface de fibres de SiC ;
- figure 6a et 6b : de fibres de SiC avec un revêtement de nanotubes de carbone moins dense ; figure 6c : de colonnes ayant poussé à certains endroits ; figure 6d :d'un agrandissement montrant les nanotubes de carbone enveloppés dans les colonnes ; figure 6e : de la base de la colonne ; figure 6f : un petit fagot de nanotubes de carbone enveloppés à leur base ;
- figure 7a et 7b : de fibres de carbone recouvertes de nanotubes de carbone courts ; figure 7c : de fibres de carbone revêtues de fibres de nanotubes de carbone très longs (croissance à 900°C) ; et figure 7d : fagots de nanotubes de carbone alignés avec croissance à certains endroits de fibres de carbone oxydées. ;
- figure 8: de nanotubes sur un support de fumées de silice ;
- figure 9 : de composites résine et fibres longues de carbone avec ou sans NTC ;
- figure 10 : de composites résines et SiCp avec ou sans NTC ;
- figure 11 : les courbes de traction comparatives pour SiCp (0,5% en poids), résine epoxy et (SiCp + NTC) 0,5% en poids ; et
- figure 12a et 12b : des particules d'argile (figure 12a) et des fibres de verre (figure 12b) avec un revêtement de nanotubes.

On rapporte ci-après le résultats d'expériences réalisées comme suit :

### Protocole expérimental général

Le dispositif utilisé comprend :
- un four électrique de 75 cm de long, équipé d'un tube de quartz de 40 mm de diamètre interne;
- 2 tubes, situés à l'entrée du réacteur, de diamètres internes différents, respectivement de 4 mm et de 0,5 mm, l'un des tubes étant utilisé pour l'introduction de gaz, le deuxième pour celle des composés mis en oeuvre.

Le tube de plus petite dimension est inséré dans le tube de plus gros diamètre, ce qui permet son refroidissement par le flux de gaz qui traverse le plus gros tube et facilite le contrôle du débit des composés liquides.

Les entrées des 2 tubes sont raccordées dans une zone à une température de 150-300°C.

Dans ces expériences, la source de carbone est constituée par du xylène et le catalyseur par du ferrocène (Fe(C₅H₅)₂).

Les matériaux céramiques, fibres de carbone, particules et fibres de SiC, TiC, Al₂O₃, SiO₂, fumées de silice, B₄C sont disposés dans un récipient en céramique, placé ensuite au centre du tube en quartz.

Le four est alors chauffé jusqu'à la température, de croissance de 600-1100°C.

Pendant la montée en température du four, on fait passer un courant d'azote dans le réacteur à un débit de 100 à 2000 ml/min. Lorsque la température de croissance est atteinte, on utilise un mélange de gaz N₂/H₂ à la place du courant d'azote, avec un rapport de 10/1 et un débit allant jusqu'à 1650 ml/min.

Un mélange de ferrocène dans du xylène, à raison de 0,001-0,1 g de ferrocène /ml de xylène, est injecté à un débit de 0, 02- 0,3 ml/min.

Le temps de croissance est généralement de quelques dizaines de minutes selon la densité et la longueur des nanotubes souhaitées, notamment de 10 à 30 min.

Le cycle ci-dessus peut être suivi de séquences thermiques pour améliorer si souhaité l'adhésion entre les nanotubes et les supports.

Le four est ensuite refroidi jusqu'à la température ambiante, sous flux d'azote de 500 ml/min, et le produit récupéré du réacteur.

### Prétraitement de fibres de carbone avec SiO

Avant l'introduction de la source de carbone, le matériau-support est traité à température élevée avec SiO en procédant comme suit :
On introduit de la poudre commerciale de SiO dans un récipient en céramique. Le produit source de carbone est alors disposé sur la poudre de SiO. Le four est chauffé jusqu'à une température de 1150°C sous flux d'azote (500 sccm) et maintenu à cette température durant 6h.

### Nanotubes sur la surface des particules de SiC

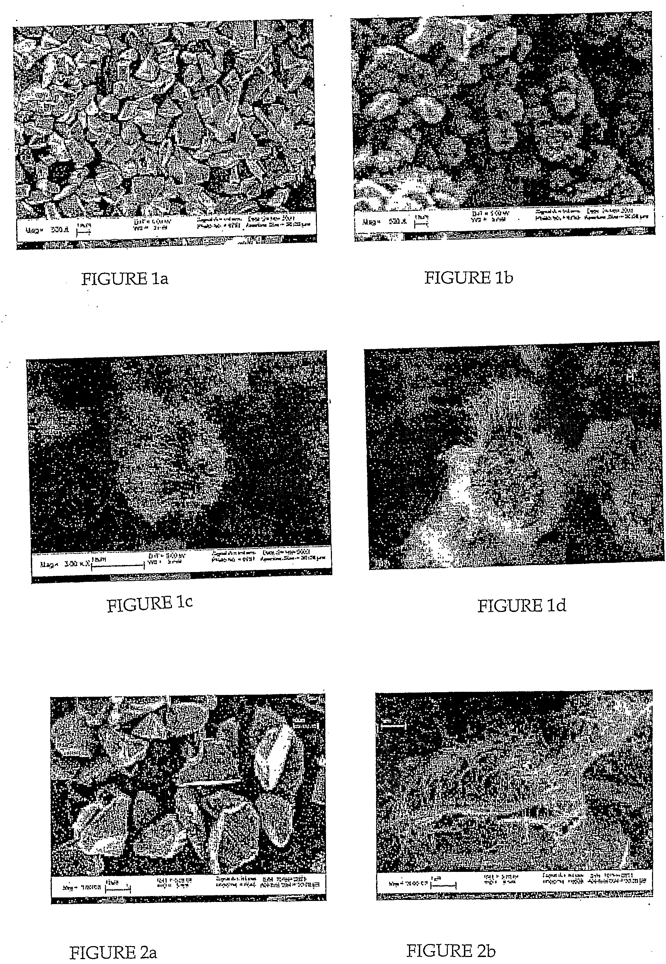

La figure 1a représente une photo des particules de SiC utilisées dans le procédé de l'invention. Ces particules ont un diamètre de 10 µm environ, présentent une forme irrégulière et pour la plupart une ou plusieurs surfaces planes. La poudre de SiC est disposée sur un récipient plat en céramique selon une épaisseur d'environ 0,5 mm. Après la croissance des nanotubes de carbone à leur surface, la poudre de SiC devient noire et les particules forment des flocons qui peuvent être aisément enlevés du récipient en céramique, ce qui démontre que les nanotubes de carbone croissent de manière uniforme à la surface de toutes les particules de SiC.

L'observation en SEM confirme ces résultats.

La figure 1b est une photo SEM à faible grossissement d'un produit obtenu conformément à l'invention, avec un temps de croissance de 25 min.

Pratiquement toutes les particules de SiC sont couvertes de manière dense de nanotubes de carbone.
La longueur des nanotubes de carbone dépend du temps de croissance. Des nanotubes de 10-20 µm sont obtenus avec un temps de croissance de 25 min.

Les figures 1c et 1d représentent des photos avec zoom sur une particule. On remarquera que les nanotubes de carbone sont alignés et perpendiculaires à la surface plate supérieure. Sur d'autres surfaces, les nanotubes n'apparaissent pas alignés et leur densité est également plus faible, ce qui démontre que la croissance des nanotubes de carbone sur SiC est sélective selon les différentes faces du cristal.

La densité et la longueur des nanotubes de carbone peuvent être contrôlés par des paramètres expérimentaux tels que le temps de croissance et la teneur en ferrocène de la solution de xylène.

Des nanotubes de carbone plus denses et plus longs peuvent être obtenus à la surface de particules de SiC avec des durées plus longues et des teneurs plus importantes en ferrocène.

La figure 2a montre un échantillon avec une densité plus faible en nanotubes de carbone (le temps de croissance est dans ce cas de 15 min) et la figure 2b représente un agrandissement correspondant. La longueur des nanotubes de carbone qui se sont développés est de quelques µm et ils apparaissent peu denses.

### Nanotubes sur la surface de fibres de carbone ayant subi un pré-traitement selon l'invention

On opère comme indiqué dans les conditions générales données ci-dessus.

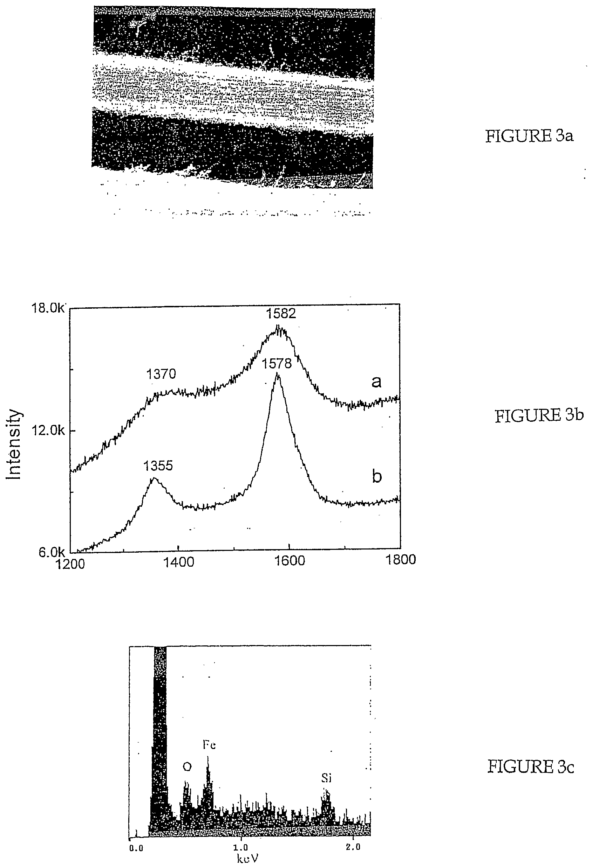

Comme illustré par la figure 3a, la croissance des nanotubes s'effectue aisément sur les fibres de carbone prétraitées. Ces résultats sont reproductibles lorsqu'on opère à des températures inférieures de l'ordre de 750-850°C. L'examen de la figure 3a montre que les nanotubes sont répartis de manière homogène dans le revêtement et sont enchevêtrés. L'épaisseur du revêtement varie de 400 à 1000 nm . A l'examen en SEM, on observe très peu de particules attachées à la surface des fibres de carbone, ce qui montre que la surface traitée par SiO est activée pour former un support pour les particules de catalyseur pour la croissance des nanotubes. L'observation en TEM (figure 3b) révèle que le revêtement est formé de nanotubes de carbone de grande qualité avec un diamètre de 20 à 30 nm. Le spectre Raman montre également que les nanotubes de carbone obtenus présentent une graphitisation importante (figure 3c). On observe des pics Raman principaux à 797 et 972 cm⁻¹. Les résultats de l'étude EDX (figure 3c) montrent que les éléments Si et O existent à la surface des fibres de carbone ayant subi le pré-traitement, avec ou sans, revêtement de nanotubes de carbone, ce qui démontre que le revêtement de Si-0 se formerait après les traitement.

### Nanotubes sur la surface des fibres de Al₂O₃

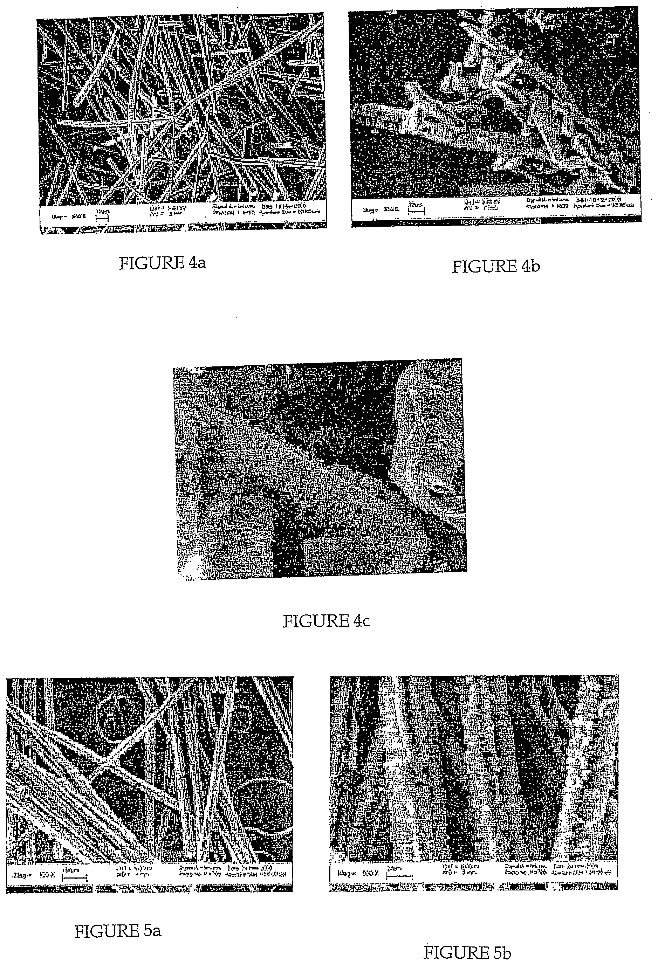

La figure 4a montre une photo de fibres de Al₂O₃ avant la croissance de nanotubes de carbone.

Ces fibres présentent un diamètre de 2-7 µm et 10 µm de long. L'observation SEM indique que leur surface est très lisse.

En utilisant les mêmes conditions expérimentales qu'avec les particules de SiC, on obtient une croissance dense de nanotubes de carbone alignés à la surface des fibres de Al₂O₃, comme illustré par les figures b-d.

On observe une couverture uniforme de toute la surface des fibres de Al₂O₃ avec les nanotubes de carbone, même aux deux extrémités.

Le diamètre des nanotubes de carbone apparaît plus faible que dans le cas de SiC.

Comme illustré par la figure 4c, les nanotubes de carbone ont tendance à se courber sur un côté de la fibre de Al₂O₃ du fait du caractère flexible des nanotubes de plus petit diamètre.

### Nanotubes sur la surface des fibres de SiC

On utilise des fibres continues de NLM-Nicalon, de diamètre d'environ 10 µm. Ces fibres sont coupées en fibres plus courtes de et placées dans un récipient en céramique.

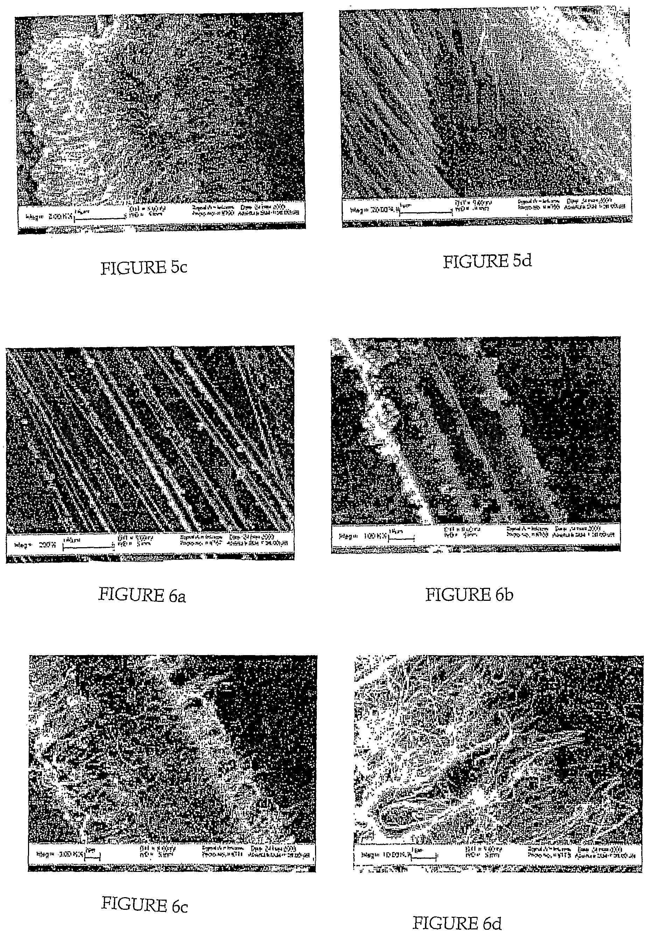

La figure 5 montre des photos de ces fibres avec un revêtement de nanotubes de carbone, obtenu avec une température de croissance de 700°C et un temps de croissance de 30 min.Le mélange ferrocène/xylène a été injecté à raison d'environ 0,05 ml/min et la quantité totale de gaz (N₂/H₂=10/1) de 1650 ml/min.

On constate.que les nanotubes de carbone sont alignés et couvrent une partie importante de la surface des fibres de SiC.

L'épaisseur des couches de nanotubes de carbone est d'environ 15 µm, ce qui indique que la vitesse de croissance des nanotubes est d'environ 0,5 µm/min.

Les figures 5a, b et C sont des photos SEM de fibres de SiC avec les revêtement de nanotubes de carbone alignés.

La figure 5d montre une photo SEM indiquant que les nanotubes de carbone croissent perpendiculairement à partir de la surface des fibres de SiC. La figure 5d montre que presque tous les nanotubes sont perpendiculaires à la surface des fibres de SiC et qu'ils ont la même longueur.

Il apparaît que peu de particules de catalyseur sont attachées à la racine des nanotubes, ce qui indique que le mécanisme de croissance principal des nanotubes sur le support de fibres de SiC est du type de croissance par l'extrémité.

Il est donc aisé de contrôler la densité des alignements de nanotubes en réglant la teneur en ferrocène dans la solution de xylène. Il est également aisé d'ajuster l'épaisseur du revêtement en changeant le temps de croissance.

Les figures 6a à 6f correspondent à des photos SEM d'un produit, pour un temps de croissance de 15 min. On constate que la surface des fibres de SiC n'est pas complètement revêtue par les nanotubes alignés. Ainsi, sur les figures 6b et c, quelques parties de la surface sont couvertes d'un faible densité de nanotubes enchevêtrés. A quelques endroits, des colonnes irrégulières de 4-5 µm de haut poussent à la surface de la fibre.

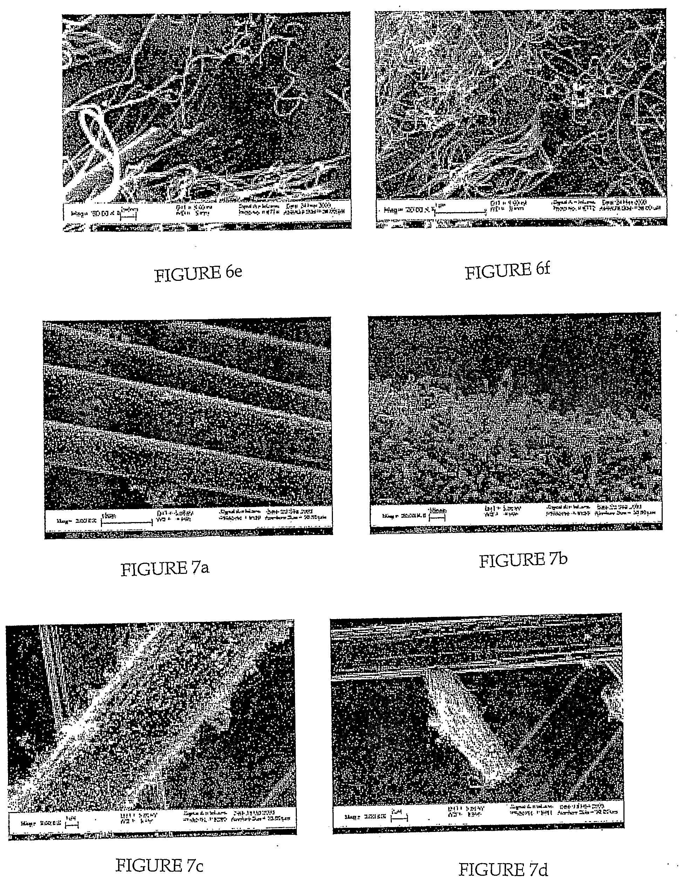

L'examen de la figure 6d montre encore que de nombreux nanotubes sont enveloppés dans ces colonnes et que leur base est fortement attachée à la surface de la fibre (figure 6e).

Dans la figure 6f, la racine d'un petit faisceau de nanotubes est juste enveloppé, ce qui démontre que l'interface de contact entre les nanotubes et la fibre est très fort à ces endroits.

### Nanotubes sur la surface des fibres de carbone

On dispose au milieu du tube une feuille de quartz sur laquelle on a placé les fibres de carbone.

Avant d'injecter la solution réactionnelle, les fibres de carbone sont préchauffées à une température d'au moins 700°C, dans le flux d'azote, pour éliminer tout polymère autour de la fibre.

La solution préparée est injectée de manière séquentielle dans le four pour tous les temps réactionnels, à différentes vitesses d'injection, de 0,05ml/min à 0,2 ml/min et la température de la réaction est maintenue à 600-900°C.

Les figures 7a et 7b montrent les images SEM de nanocomposites de fibres de carbone/nanotubes multifeuillets très courts et dispersés, qui croissent à 700°C avec un temps de croissance de 30 min. Le diamètre des fibres de carbone avant la croissance des nanotubes multifeuillets par CVD est de 7µm et le diamètre des fibres de carbone après des nanotubes multifeuillets est de 8-8,5 µm, de sorte que l'épaisseur de la région des nanotubes multifeuillets entourant la fibre sont de l'ordre de 0,5 à 0,75 µm.

La vue agrandie des nanotubes révèle que la majorité des nanotubes multifeuillets sont orientés vers le haut, mais ne sont pas verticaux (Figure 7b).

La longueur des nanotubes multifeuillets et d'environ 0,2 à 0,7 µm et le diamètre extérieur est d'environ 80-100 nm.

La figure 7c montre une fibre de carbone avec un très long revêtement de nanotubes (sa température de croissance est de 900°C). Pour améliorer la croissance des nanotubes sur les fibres de carbone, ces fibres ont été soumises à un traitement thermique à l'air et la croissance des nanotubes a été effectuée sur ces fibres traitées. Comme le montre la figure 7d, des fagots de nanotubes alignés peuvent croître à quelques endroits des fibres de carbone oxydées.

### Nanotubes sur les particules de fumées de silice

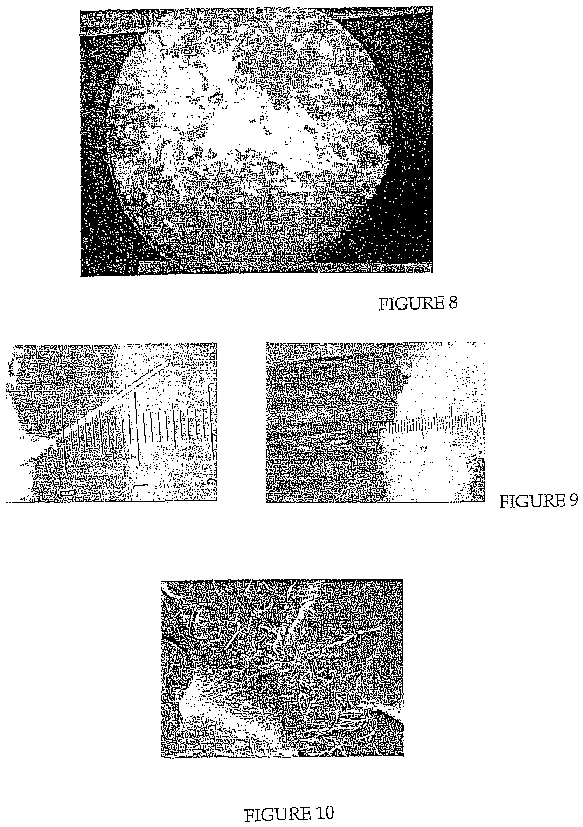

On opère comme indiqué ci-dessus, en utilisant de la micro-silice (fumées de silice). La figure 8 montre les nanotubes développés sur les particules de micro-silice en opérant comme indiqué ci-dessus.

### Production de composites NTC/céramiques/matrice.

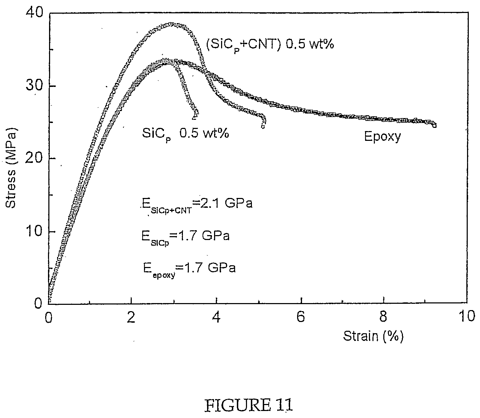

Deux types de composites sont utilisés :
1. Des composites résine et fibres longues de carbone avec ou sans NTC : le déchaussement a été observé avec des fibres de carbone conventionnelles (type T300, 7 µm en diamètre) imprégnées de résine époxy sans dépôt de NTC, mais pas sur celles qui comportent ce dépôt (Fig. 9).
2. Des composites résine et SiCp avec ou sans NTC : après mélange avec de la résine, on constate que les NTC restent toujours autour des SiCp (Fig. 10). Sur les faciès de rupture des composites (résine, SiCp et NTs), une surface lisse a été observée sur des SiCp sans nanotubes, tandis que la rupture a eu lieu dans la matrice lorsque les SiCp couvertes de NTC ont été utilisées. Comme le montre la figure 9, une bonne dispersion des SiCp+NTC est obtenue. Les courbes de traction comparatives sont données dans la figure 11. Un effet de renforcement remarquable par SiCp+NTC à 0.5% en masse a été obtenu, par rapport au même taux en SiCp.

Des composites à matrice d'un alliage de Mg et d'un alliage d'Al comportant des SiCp couvertes de NTC ont été également étudiés.

### Nanotubes sur support des particules d'argile

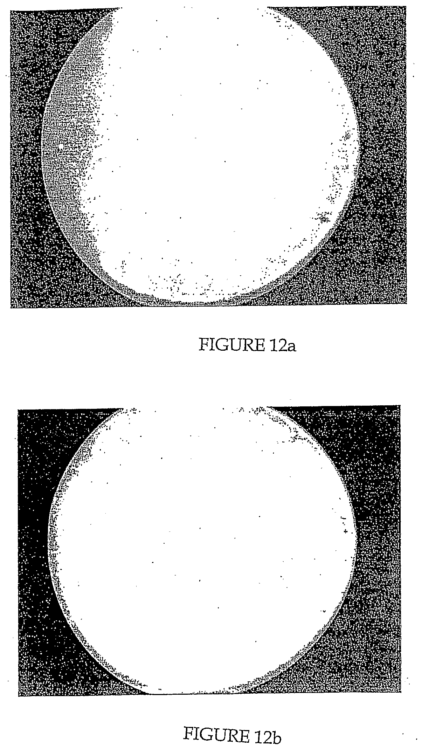

La figure 12a illustre les nanotubes déposés sur de tels supports en opérant selon l'invention.

### Nantoubes sur support de fibres de verre

La figure 12b illustre de tels supports avec revêtement de nanotubes.

## Revendications

1. Procédé d'obtention de nanotubes de carbone liés à des supports en matériau céramique ou fibres de carbone de dimension nanométrique et/ou micrométrique, **caractérisé en ce qu'**il comprend :
- la mise en contact desdits supports avec un mélange d'un composé source de carbone et d'un catalyseur, sous un courant de gaz inerte et d'hydrogène, la mise en contact étant réalisée par dépôt chimique en phase vapeur (CVD).

2. Procédé selon la revendication 1, comprenant également :
- le chauffage, dans une enceinte réactionnelle, desdits supports, à une température de 600-1100°C, sous un courant de gaz inerte,
- le refroidissement de l'enceinte jusqu'à la température ambiante,
- la récupération des nanotubes de carbone liés auxdits supports.

3. Procédé selon la revendication 2, dans lequel le matériau céramique se présente sous forme de particules ou de fibres.

4. Procédé selon la revendication 3, dans lequel le matériau céramique est formé de fibres de carbone, fibres de verre, particules et fibres de SiC, TiC, Al₂O₃, SiO₂, B₄C, fumées de silice, les argiles (grains d'argile), ou fils comportant un matériau métallique choisi dans le groupe comprenant Fe, Ni, Co, Ti, Pt, Au, Y, Ru, Rh, Pd, Zr, Cr, et Mn.

5. Procédé selon l'une quelconque des revendications 1 à 4, dans lequel le composé source de carbone est choisi parmi les hydrocarbures liquides du groupe comprenant le xylène, le toluène, le benzène, et le n-pentane ; les alcools ; les cétones ; les hydrocarbures gazeux du groupe comprenant l'acétylène, le méthane, le butane, le propylène, l'éthylène et le propène ; et le camphore.

6. Procédé selon l'une quelconque des revendications 1 à 5, dans lequel le catalyseur est choisi dans le groupe comprenant un métallocène de fer, de cobalt ou de nickel, ou encore des nitrates, ces acétates ou des sulfates de fer, de cobalt ou de nickel.

7. Procédé selon l'une quelconque des revendications 1 à 6, dans lequel le catalyseur et le composé source de carbone sont utilisés à raison de 0,001 à 0,1 g de catalyseur par ml de composé.

8. Procédé selon l'une quelconque des revendications 2 à 7, dans lequel le rapport de gaz inerte et d'hydrogène est de 5/95 à 50/50.

9. Procédé selon l'une quelconque des revendications 1 à 8, dans lequel avant ladite étape de chauffage du support, ledit support est traité avec un composé comprenant du silicium, dans des conditions permettant le dépôt de silicium ou d'un dérivé de silicium choisi dans le groupe comprenant le SiC, SiO et SiO₂ à la surface du support.

10. Procédé selon la revendication 9, dans lequel le composé comprenant du silicium est SiO ou un silane.

11. Procédé selon l'une quelconque des revendications 1 à 10, comprenant en outre une étape de mélange des nanotubes de carbone liés auxdits supports à une matrice polymère, métallique ou céramique.

## Patentansprüche

1. Verfahren zum Erhalten von Kohlenstoffnanoröhrchen, die mit Trägern aus keramischem Material oder Kohlenstofffasern mit nanometrischer und/oder mikrometrischer Abmessung verbunden sind, **dadurch gekennzeichnet, dass** es Folgendes umfasst:
- In-Kontakt-Bringen der Träger mit einer Mischung einer Kohlenstoffquellenverbindung und eines Katalysators unter einer Inertgas- und Wasserstoffströmung, wobei das In-Kontakt-Bringen durch chemische Gasphasenabscheidung (CVD) durchgeführt wird.

2. Verfahren nach Anspruch 1, ebenfalls umfassend:
- Erhitzen, in einem Reaktionsbehälter, der Träger auf eine Temperatur von 600 - 1100 °C unter einer Inertgasströmung,
- Abkühlen des Behälters auf die Umgebungstemperatur,
- Rückgewinnen der Kohlenstoffnanoröhrchen, die mit den Trägern verbunden sind.

3. Verfahren nach Anspruch 2, wobei das keramische Material die Form von Partikeln oder von Fasern aufweist.

4. Verfahren nach Anspruch 3, wobei das keramische Material aus Kohlenstofffasern, Glasfasern, Partikeln und SiC-, TiC-, Al₂O₃-, SiO₂-, B₄C-Fasern, Silikastaub, Ton (Tonkörner) oder Fäden, umfassend ein metallisches Material, ausgewählt aus der Gruppe, umfassend Fe, Ni, Co, Ti, Pt, Au, Y, Ru, Rh, Pd, Zr, Cr und Mn, gebildet ist.

5. Verfahren nach einem der Ansprüche 1 bis 4, wobei die Kohlenstoffquellenverbindung ausgewählt ist aus flüssigen Kohlenwasserstoffen der Gruppe, umfassend Xylen, Toluen, Benzen und n-Pentan; Alkohole; Ketone; gasförmige Kohlenwasserstoffe der Gruppe, umfassend Acetylen, Methan, Butan, Propylen, Ethylen und Propen; und Campher.

6. Verfahren nach einem der Ansprüche 1 bis 5, wobei der Katalysator ausgewählt ist aus der Gruppe, umfassend ein Eisen-, Kobalt- oder Nickelmetallocen oder auch Eisen-, Kobalt- oder Nickelnitrate, -acetate oder - sulfate.

7. Verfahren nach einem der Ansprüche 1 bis 6, wobei der Katalysator und die Kohlenstoffquellenverbindung in einer Menge von 0,001 bis 0,1 g Katalysator pro ml Verbindung verwendet werden.

8. Verfahren nach einem der Ansprüche 2 bis 7, wobei das Verhältnis zwischen Inertgas und Wasserstoff 5/95 bis 50/50 ist.

9. Verfahren nach einem der Ansprüche 1 bis 8, wobei vor dem Schritt des Erhitzens des Trägers der Träger mit einer Verbindung behandelt wird, umfassend Silicium, unter Bedingungen, die die Ablage von Silicium oder eines Derivats von Silicium, ausgewählt aus der Gruppe, umfassend SiC, SiO und SiO₂, auf der Oberfläche des Trägers ermöglichen.

10. Verfahren nach Anspruch 9, wobei die Verbindung, die Silicium umfasst, SiO oder ein Silan ist.

11. Verfahren nach einem der Ansprüche 1 bis 10, umfassend außerdem einen Schritt des Mischens der Kohlenstoffnanoröhrchen, die mit den Trägern verbunden sind, mit einer Polymer-, Metall- oder Keramikmatrix.

## Claims

1. A process for obtaining carbon nanotubes bound to nanometric and/or micrometric sized ceramic material or carbon fiber supports, **characterized in that** it comprises:
- contacting said supports with a mixture of a carbon source compound and a catalyst, under a stream of inert gas and hydrogen gas, the contacting step being effected by chemical vapor deposition (CVD).

2. Process as claimed in claim 1, further comprising:
- heating said supports in a reaction chamber at a temperature of 600-1100°C, under a stream of inert gas,
- cooling the chamber down to room temperature; and
- recovering the carbon nanotubes bound to said supports.

3. Process as claimed in claim 2, wherein the ceramic material is in the form of particles or fibers.

4. Process as claimed in claim 3, wherein the ceramic material is made of carbon fibers; glass fibers; SiC, TiC, Al₂O₃, SiO₂ or B₄C particles and fibers; silica fumes; clays (clay particles); or wires comprising a metallic material selected from the group comprising Fe, Ni, Co, Ti, Pt, Au, Y, Ru, Rh, Pd, Zr, Cr and Mn.

5. Process as claimed in any one of claims 1 to 4, wherein the carbon source compound is selected from liquid hydrocarbons from the group comprising xylene, toluene, benzene and n-pentane; alcohols; ketones; gaseous hydrocarbons from the group comprising acetylene, methane, butane, propylene, ethylene and propene; or camphor.

6. Process as claimed in any one of claims 1 to 5, wherein the catalyst is selected from the group comprising an iron, cobalt or nickel metallocene; or else iron, cobalt or nickel nitrates, acetates or sulfates.

7. Process as claimed in any one of claims 1 to 6, wherein the catalyst and the carbon source compound are used in an amount from 0.001 to 0.1 g of catalyst per ml of compound.

8. Process as claimed in any one of claims 2 to 7, wherein the ratio of inert gas to hydrogen is 5/95 to 50/50.

9. Process as claimed in any one of claims 1 to 8, wherein, before the step of heating the support, said support is treated with a silicon-containing compound, under conditions allowing the deposit of silicon or a silicon derivative selected from the group comprising SiC, SiO and SiO₂ on the surface of the support.

10. Process as claimed in claim 9, wherein the silicon-containing compound is SiO or a silane.

11. Process as claimed in any one of claims 1 to 10, further comprising a step of mixing carbon nanotubes bound to said supports to a polymer, metal or ceramic matrix.
